# EUROPÄISCHE PATENTANMELDUNG

(11) **EP 0 773 200 A1**
(43) Veröffentlichungstag der Anmeldung: **14.05.1997**
(21) Anmeldenummer: 96117283.0
(22) Anmeldetag: 28.10.1996
(51) Int. Cl.: C04B 35/45, C04B 35/64, C04B 35/653

(54) **Hochtemperatursupraleitende texturierte Formteile und Verfahren zu ihrer Herstellung**

(30) Priorität: 09.11.1995 DE 19541756
(71) Anmelder: HOECHST AKTIENGESELLSCHAFT, 65929 Frankfurt am Main (DE)
(72) Erfinder: Gross, Christoph, 60594 Frankfurt (DE); Elschner, Steffen, Dr., 69121 Heidelberg (DE); Brommer, Günther, 65185 Wiesbaden (DE); Assmus, Wolf, Prof. Dr., 63452 Hanau (DE)

(57) **Zusammenfassung**

Die Erfindung betrifft ein Verfahren zur Herstellung von texturierten hochtemperatursupraleitenden Formteilen, bei dem Formteile aus oxidkeramischem Material, das hochtemperatursupraleitend ist oder bei geeigneter Behandlung hochtemperatursupraleitend wird, zunächst geformt und gegebenenfalls auch gesintert oder/und erschmolzen werden oder/und nach einem Schmelzen geformt werden, wobei die Formteile dann entlang einer Längsachse eine zonenweise thermische Behandlung erfahren, das dadurch gekennzeichnet ist, daß die Formteile in der heißesten Zone eines Ofens mindestens partiell oder/und unvollständig aufgeschmolzen werden, wobei die notwendige Energie teilweise oder gänzlich durch ein elektromagnetisches Wechselfeld aufgebracht wird.

## Beschreibung

Die vorliegende Erfindung betrifft ein Verfahren zur Herstellung von oxidkeramischen hochtemperatursupraleitenden Formteilen mit einer Textur sowie entsprechend hergestellte Formteile und ihre Verwendung.

Oxidkeramische Hochtemperatursupraleiter gelten als aussichtsreiche Materialien für Formteile oder Bauteile im Bereich der Elektrotechnik und Elektronik, da ihre hohen Sprungtemperaturen einen Betrieb in flüssigem Stickstoff ermöglichen und eine Kühlung mit flüssigem Helium nicht erforderlich ist. Voraussetzung für ihre breite wirtschaftliche Anwendung ist aber eine hohe Stromdichte j_{c}. Nach den Untersuchungen von Dimos et al. in Physical Review B, Vol. 41, 1990, 4038-4049 hängt die kritische Transportstromdichte in YBCO-Werkstoffen von den Winkeln zwischen den kristallographischen Achsen einzelner Kristallite ab. Je weniger die Winkel in einem Formteil abweichen, desto größer ist die kritische Transportstromdichte.

Zur Herstellung von hochtemperatursupraleitenden Massivteilen sind verschiedene Verfahren bekannt. So können z.B. durch Schleuderguß Rohre und Stäbe aus der Verbindung mit einer Zusammensetzung ungefähr von Bi₂Sr₂CaCu₂Oₓ (BSCCO 2212) hergestellt werden, die je nach Bauform bis zu 7 kA Strom tragen können (Hoechst High Chem, Materials for Superconductor Technology, Issue 3, Sept. 1995). Für die Verbindung mit einer Zusammensetzung ungefährt von YBa₂Cu₃Oₓ (YBCO 123) wurden sowohl Herstellungsverfahren beschrieben, die keinen Temperaturgradienten verwenden (melt-texture growth, S. Jin et al., Appl. Phys. Letts. 52, 2074, 1988), als auch solche, bei denen ein Temperaturgradient verwendet wird (McGinn et al., Appl. Phys. Letts. 57, 1455, 1990). Insbesondere für die letztgenannte Verbindungsklasse ist die Herstellung von Bauteilen erwünscht, die einen möglichst hohen Anteil supraleitender Phasen und möglichst große einkristalline Domänen enthalten, da die schlechte Kopplung ("weak links") zwischen den supraleitenden Körnern die erreichbare Stromdichte herabsetzt. So können bei der Herstellung von Bauteilen nach den in der technischen Keramik herkömmlichen Formgebungsverfahren bisher nur geringe kritische Stromdichten von nicht über 1000 A/cm² erreicht werden. Allgemein gilt, daß der Wert für den Sauerstoffgehalt "X" bei Zusammensetzungen und Verbindungen von Hochtemperatursupraleitern in etwa dem stöchiometrischen Äquivalent der Summe der Kationen entspricht oder ein Sauerstoffdefizit bis zu -0.8 gegenüber dem stöchiometrischen Äquivalent aufweist.

Brand et al. beschreiben ein Zonenschmelzverfahren zur Herstellung von texturierten Stäben aus YBCO 123 mit einer Länge von etwa 8 cm und einem Durchmesser von etwa 8 mm (Appl. Phys. Lett. 64 (15), 2022, 1994). Hierbei wurde die geschmolzene Zone durch ein ringförmiges Widerstandsheizelement erzeugt, was einer reinen Strahlungsheizung entspricht. Im Zonenschmelzofen entsteht hierbei ein Material mit einer bevorzugten kristallographischen Orientierung, bei der die c-Achse um ca. 55° gegen die Stabachse geneigt ist. Diese Orientierung ist im Hinblick auf eine mögliche technische Anwendung des Materials, etwa als Hochstromzuführung, nicht optimal, da hierfür u.a. eine möglichst weit ausgerichtete Textur erwünscht ist, bei der die c-Achse der Kristallstruktur mit der Stabachse einen Winkel möglichst nahe bei 90° einschließt, um das Maximum der Stromdichte parallel zu den (a,b)-Ebenen optimal auszunutzen und die Stromdichten möglichst genau in Richtung der Stabachse zu gewährleisten. Dieses Verfahren kann jedoch helfen, ein texturiertes polykristallines Material bzw. ein nahezu einkristallines Material zu erzeugen. In WO 95/02717 werden zwei Verfahren zur Ausbildung der Textur eines supraleitenden YBCO-Materials beschrieben, bei dem die c-Achse mittels eines auf einer konischen Spitze angeordneten Impfkristalls oder eines durch Kühlungsbleche und Temperaturstufen schräg ausgerichteten Temperaturgradienten im Zonenschmelzofen möglichst weit auf die Senkrechte zur Stabachse ausgerichtet werden.

Das bevorzugte Auftreten der Orientierung von ca. 55° läßt sich aus der vorliegenden Form der flüssig-fest-Phasengrenze und der materialtypischen Anisotropie der Wärmeleitfähigkeit erklären. Im verwendeten Zonenschmelzofen mit Strahlungsheizung war die Phasengrenze, von den festen Stabenden her gesehen, immer stark konvex, d.h. im Bereich der Schmelzzone hat der partiell aufgeschmolzene Stab auf der Staboberfläche immer eine höhere Temperatur als im Bereich der Stabachse. Die Krümmung der Phasengrenze läßt sich durch Variation der Ofenparameter nur in engen Grenzen beeinflussen.

Aufgabe der vorliegenden Erfindung war es daher, ein geeignetes Verfahren bereitzustellen, mit dem ohne Änderung der Form des Formteiles durch konisches Anspitzen bzw. ohne Änderung des Temperaturgradienten durch Neigung der Kühlbleche und Temperaturstufen des Ofens eine andere als die 55°-Orientierung zur Stabachse eingestellt werden kann. Das Verfahren sollte möglichst einfach und universell für unterschiedliche Werkstoffe und Formteilgeometrien einzusetzen sein.

Diese Aufgabe wird gelöst durch ein Verfahren zur Herstellung von texturierten hochtemperatursupraleitenden Formteilen, bei dem Formteile aus oxidkeramischem Material, das hochtemperatursupraleitend ist oder bei geeigneter Behandlung hochtemperatursupraleitend wird, zunächst geformt und gegebenenfalls auch gesintert oder/und erschmolzen werden oder/und nach einem Schmelzen geformt werden, wobei die Formteile dann entlang einer Längsachse eine zonenweise thermische Behandlung erfahren und das dadurch gekennzeichnet ist, daß die Formteile in der heißesten Zone eines Ofens mindestens partiell oder/und unvollständig aufgeschmolzen werden, wobei die notwendige Energie teilweise oder gänzlich durch ein elektromagnetisches Wechselfeld aufgebracht wird.

Es wurde überraschend gefunden, daß die Form und Größe der Schmelzzone des Formteils im Ofen durch geeignete Wahl der Anteile von induktiver Erwärmung im Inneren des Formteils und Strahlungsheizung von außen beeinflußt werden kann. Der Ofen kann mehrere Heizzonen aufweisen und auch typische Merkmale eines Zonenschmelzofens aufweisen. Hiermit kann sowohl das zukünftige Gefüge, als auch die Orientierung des supraleitenden Materials auf einfachem Weg beeinflußt und optimiert werden.

Eine induktive Heizung besteht im Prinzip aus einer Wechselstromquelle und einer Induktorspule, die im Formteil elektrische Ströme induzieren und es dadurch erwärmen. Hierdurch kann das Innere eines Formteils auf eine höhere Temperatur als die Randbereiche des Formteils gebracht werden. Induktive Heizverfahren werden in Forschung, Entwicklung und Produktion für eine Vielzahl oxidischer und nicht-oxidischer Materialien verwendet und sind in der Fachliteratur ausgiebig beschrieben.

Die für diese Erfindung verwendeten Frequenzen umfassen den Bereich von 50 Hz bis 5 GHz, vorzugsweise von 100 kHz bis 1 GHz, besonders bevorzugt von 1 MHz bis 100 MHz bzw. von 5 MHz bis 70 MHz, insbesondere von 10 MHz bis 60 MHz bzw. von 15 MHz bis 30 MHz, und müssen für den jeweiligen Anwendungsfall an die Geometrie und den spezifischen Widerstand des Formteils angepaßt werden, da anderenfalls der Wirkungsgrad stark absinkt.

Unter Berücksichtigung der gegebenen Stababmessungen, des spezifischen Widerstands des Materials, der Verfügbarkeit von Hochfrequenz-Generatoren geeigneter Leistung und des spezifischen elektrischen Widerstandes des Spulenmaterials wurde für das Beispiel 1 eine Frequenz von 27,13 MHz gewählt. Aus technischen Gründen werden HF-Generatoren in diesem Frequenzbereich jedoch nicht als Freischwinger (d.h. mit variabler Frequenz) betrieben, wie dies bei der induktiven Erwärmung im Bereich unterhalb 10 MHz üblich ist. Da derartige Generatoren außerdem nur eine beschränkte Fehlanpassung tolerieren, wurde ein Anpassungsnetzwerk (Matchbox) zur Anpassung der Generator- an die Lastimpedanz aufgebaut.

Aufgrund ihres eigenen elektrischen Widerstandes erwärmt sich die Induktorspule ebenfalls, wodurch das Formteil nicht nur vorwiegend im Inneren induktiv, sondern auch von außen und daher im Randbereich durch die Wärmestrahlung der heißen Spule erhitzt wird. Durch die Wahl eines Spulenmaterials mit geeignetem spezifischen Widerstand und evtl. auch einer geeigneten Kühlung kann das Verhältnis des induktiven Anteils zum Strahlungsanteil und die damit verbundene Form der Phasengrenze in einem weiten Bereich sowie untergeordnet die Größe der Schmelzzone eingestellt werden (nahezu 100% Strahlungsheizung bis 100% induktive Heizung). Damit kann die Ausbildung einer Textur, ihre Orientierung und die Ausbildung von großen einkristallinen Domänen einfach und gut kontrolliert werden.

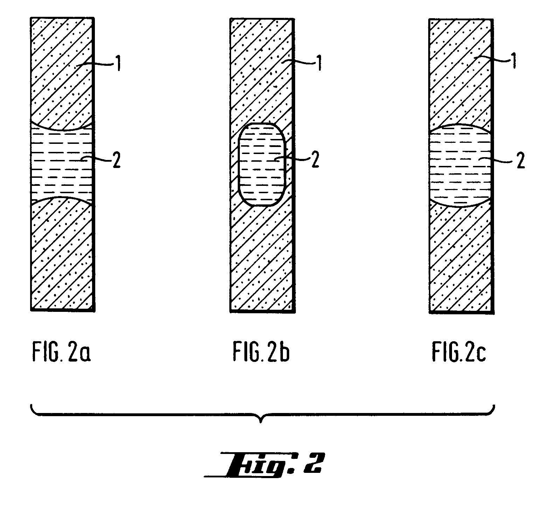

Eine Kombination aus Strahlungsheizung und induktiver Heizung erscheint aus einem weiteren Grund sinnvoll. Formteile aus Materialien, die beim Erwärmen Gase abgeben oder vor dem Erwärmen noch nicht 100% ihrer theoretischen Dichte erreicht haben, neigen bei ausschließlich induktiver Erwärmung zur Porenbildung, da das Formteil von innen heraus erwärmt wird, aber noch von einer geschlossenen Hülle umgeben ist. In einem Zwischenzustand der Erwärmung können im Inneren entstehende Gase schlecht entweichen bzw. entstehende Poren sich nur unvollständig schließen, da die äußere Hülle des Formteils noch fest ist. Indem der Strahlungsanteil, wie oben beschrieben, erhöht wird, kann die Ausbildung einer derartigen Hülle (siehe Figur 2b) vermieden werden. Eine derartige Hülle kann insbesondere bei Zusammensetzungen auf Basis BSCCO von Bedeutung sein, wenn die Schmelzzone gänzlich aufgeschmolzen ist, so daß kein Gerüst aus festen Partikeln in der Schmelze, sondern die Hülle um die Schmelzzone die niedrigviskose Schmelze vor dem Wegfließen schützt.

Erfindungsgemäß hergestellte Formteile besitzen bevorzugt die Geometrie von Stäben mit einer Länge von bis zu 1 m und einem Durchmesser im Bereich von 1 bis 50 mm. Es eignen sich jedoch grundsätzlich auch viele weitere Geometrien, insbesondere Hohlzylinder bis 50 mm Außendurchmesser sowie Scheiben und Quader. Es können nach diesem Verfahren Formteile aus allen oxidischen Hochtemperatursupraleitermaterialien hergestellt werden, insbesondere Materialien, die reich an BSCCO 2212 oder/und einer Verbindung mit einer Zusammensetzung ungefährt von Bi₂Sr₂Ca₂Cu₃Oₓ (BSCCO 2223), gegebenenfalls auch SrSO₄, oder YBCO 123 oder YBCO 123 mit YBCO 211 sind. Es empfiehlt sich, daß näherungsweise oder genau Materialzusammensetzungen hergestellt werden, die den Zusammensetzungen BSCCO 2212 oder/und 2223 mit 0 bis 30 Gew.-% SrSO₄, YBCO 123 mit 0 bis 25 Gew.-% YBCO 211 entsprechen.

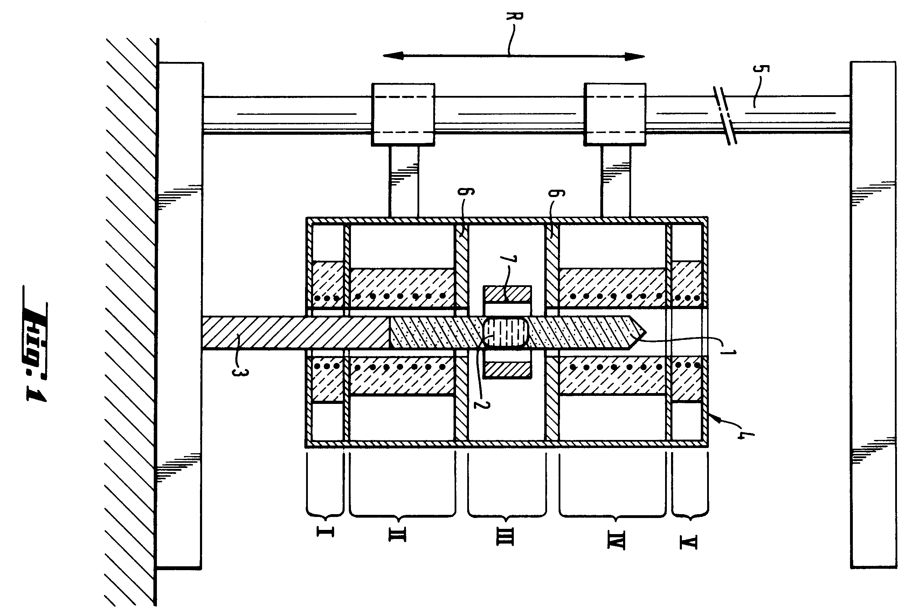

Die Figur 1 zeigt eine schematische Darstellung eines Zonenschmelzofens, wie er zur Durchführung des erfindungsgemäßen Verfahrens genutzt werden kann. Mit Bezugszeichen sind das Formteil 1, die Schmelzzone 2 und der Probenhalter 3 verdeutlicht. Der Zonenschmelzofen 4 ist an einer Halterung 5 angebracht und ist in Richtung R beweglich. Die Zonen I, II, IV und V werden durch Widerstandsheizelemente (Strahlungsheizung) beheizt. In der Zone III wird die Induktorspule 7 befestigt. Der Temperaturgradient in den Zonen II und IV läßt sich mit Hilfe von Kühlblechen 6 einstellen, die aus Nickelblech gefertigt sein können.

Die Figur 2 zeigt schematisch die Form der Schmelzzone bei
- Verwendung einer Strahlungsheizung (Widerstandsheizelement) in Zone III (links; 2a),
- Verwendung einer induktiven Heizung in Zone III (rechts; 2c),
- Verwendung einer induktiven Heizung in Zone III, jedoch ist die Schmelzzone nur partiell aufgeschmolzen (Mitte; 2b).

Die Formteile können nach dem Erzeugen der Schmelzzone und gegebenenfalls nachdem die Schmelzzone durch mindestens 50 %, mindestens 70 % oder mindestens 90 % des Formteilvolumens oder ganz hindurchgeführt wurde durch Bewegen des Formteils durch den Ofen oder/und durch Bewegen des Ofens anstelle langsamen Abkühlens abgeschreckt werden. Diese Temperaturbehandlung kann sowohl gänzlich unter Sauerstoffabschluß, besonders, wenn der Ofen vor Angriff geschützt werden soll, oder in einer Sauerstoff-haltigen Atmosphäre erfolgen. Falls bei dieser Temperaturbehandlung ohne oder ohne ausreichenden Sauerstoffgehalt gebrannt wurde, ist eine nachfolgende Temperaturstufe oder eine nachfolgende Temperaturbehandlung erforderlich, um in Sauerstoff-reicher Atmosphäre den Sauerstoffgehalt der supraleitenden Phasen einzustellen. Die Formteile können anschließend erneut auf Temperaturen von 100 bis 1 °C unter dem Schmelzpunkt der am niedrigsten schmelzenden hochtemperatur-supraleitenden Phase in einer Sauerstoff-haltigen Atmosphäre erhitzt und über 1 bis 200 h, vorzugsweise über 5 bis 100 h in diesem Temperaturbereich gehalten werden. Sie können bei einer Temperaturbehandlung zum Ausbilden einer Schmelzzone oder/und bei einer nachfolgenden Temperaturbehandlung zusätzlich bei Temperaturen zwischen 300 und 700 °C mindestens über 1 h getempert werden. In den Fällen, in denen die nach diesem Verfahren erzeugte Orientierung noch nicht ausreichend einheitlich ist, kann auf oder in die Formteile zusätzlich ein Keimkristall gebracht werden.

Die hochtemperatursupraleitenden Formteile sind dadurch gekennzeichnet, daß ihr Gefüge mindestens weitgehend einheitlich orientiert ist. Bei den erzeugten supraleitenden Formteilen können einkristalline Domänen größer als 8 mm, vorzugsweise größer als 20 mm, auftreten und können die c-Achsen der Körner der supraleitenden Phasen näherungsweise parallel oder näherungsweise in einem Winkel kleiner 10 ° zu einer der Längsachsen des Formteile ausgerichtet sein. Die supraleitenden Formteile können Poren, sollten jedoch keine Lunker aufweisen. Sie können eine kritische Stromdichte j_{c} von mindestens 10000 A/cm² aufweisen und können als Komponenten für Stromzuführungen, resistive oder induktive Strombegrenzer, Abschirmzylinder oder Permanentmagnete verwendet werden.
Die Erfindung wird nachfolgend durch ein Ausführungsbeispiel beschrieben.

### Beispiel 1:

Ausgehend von einer Pulvermischung aus YBCO 123, YBCO 211 und PtO₂ im molaren Verhältnis 100:20:3 wurde ein zylinderförmiger Rohling mit einer Länge von 10 cm und einem Durchmesser von 8 mm zunächst gepreßt und dann bis zu einer Dichte von 90 % der theoretisch möglichen Dichte gesintert. Anschließend wurde der Stab auf einem Keramikrohr befestigt und in den im Zusammenhang mit Figur 1 beschriebenen Zonenschmelzofen gebracht. Die Mitte des Rohlings befand sich dabei in der Induktorspule, die aus drei Windungen eines Nickeldrahtes (Drahtdurchmesser: 2,5 mm) besteht. Die Induktorspule hat einen Durchmesser von 16 mm und eine Länge von 11 mm. Die Temperatur der Zonen I, II, IV und V wurde auf 750 °C gebracht, d.h. 230 K unterhalb der peritektischen Schmelztemperatur. Die Nickelspule wurde über ein Anpassungsnetzwerk, bestehend aus zwei Drehkondensatoren, an einen Hochfrequenz-Generator mit einer Frequenz von 27,13 MHz angeschlossen. Der Generator wurde für zwei Stunden auf eine Ausgangsleistung von 100 W eingestellt. Während dieser Zeit wurde die Probe nicht bewegt (Anschmelzversuch). Nach dem Abkühlen wurde von der Probe ein Längsschliff angefertigt. Die Schmelzzone stellt sich im Lichtmikroskop als ein amorpher Bereich dar, der sich deutlich vom nicht aufgeschmolzenen Sintermaterial abhebt. Die Schmelzzone hat die gewünschte konkave Form - vom nicht aufgeschmolzenen Stabende her betrachtet - und ist, auf der Stabachse gemessen, etwa 10 mm lang.

## Patentansprüche

1. Verfahren zur Herstellung von texturierten hochtemperatursupraleitenden Formteilen, bei dem Formteile aus oxidkeramischem Material, das hochtemperatursupraleitend ist oder bei geeigneter Behandlung hochtemperatursupraleitend wird, zunächst geformt und gegebenenfalls auch gesintert oder/und erschmolzen werden oder/und nach einem Schmelzen geformt werden, wobei die Formteile dann entlang einer Längsachse eine zonenweise thermische Behandlung erfahren, dadurch gekennzeichnet, daß die Formteile in der heißesten Zone eines Ofens mindestens partiell oder/und unvollständig aufgeschmolzen werden, wobei die notwendige Energie teilweise oder gänzlich durch ein elektromagnetisches Wechselfeld aufgebracht wird.

2. Verfahren nach Anspruch 1, dadurch gekennzeichnet, daß die Schmelzzone durch mindestens 50 % des Formteilvolumens geführt wird durch Bewegen des Formteils durch den Ofen oder/und durch Bewegen des Ofens.

3. Verfahren nach Anspruch 1 oder 2, dadurch gekennzeichnet, daß näherungsweise oder genau Materialzusammensetzungen hergestellt werden, die den Zusammensetzungen BSCCO 2212 oder/und 2223 mit 0 bis 30 Gew.-% SrSO₄ oder YBCO 123 mit 0 bis 25 Gew.-% YBCO 211 entsprechen.

4. Verfahren nach einem der Ansprüche 1 bis 3, dadurch gekennzeichnet, daß Formteile in der Geometrie von Stäben, Hohlzylindern, Scheiben oder Quadern hergestellt werden.

5. Verfahren nach einem der Ansprüche 1 bis 4, dadurch gekennzeichnet, daß die Formteile in der heißesten Zone eines Ofens ausschließlich oder teilweise im elektromagnetischen Wechselfeld erwärmt werden, dessen Frequenz bei 50 Hz bis 5 GHz, vorzugsweise bei 10 MHz bis 60 MHz liegt.

6. Verfahren nach einem der Ansprüche 1 bis 5, dadurch gekennzeichnet, daß in der heißesten Zone eines Ofens eine Schmelzzone in einer Form erzeugt wird, deren Phasengrenze - vom festen Formteilende aus gesehen - nur schwach konvex, senkrecht zu einer Längsachse oder konkav ausgebildet ist.

7. Verfahren nach Anspruch 6, dadurch gekennzeichnet, daß die Schmelzzone mindestens teilweise von einer festen Hülle umgeben ist.

8. Verfahren nach einem der Ansprüche 1 bis 7, dadurch gekennzeichnet, daß die Formteile nach dem Erzeugen der Schmelzzone abgeschreckt werden.

9. Verfahren nach einem der Ansprüche 1 bis 8, dadurch gekennzeichnet, daß die Formteile nach dem Erzeugen der Schmelzzone und nach dem Abkühlen erneut auf Temperaturen von 100 bis 1 °C unter dem Schmelzpunkt der am niedrigsten schmelzenden hochtemperatur-supraleitenden Phase in einer Sauerstoff-haltigen Atmosphäre erhitzt und über 1 bis 200 h, vorzugsweise über 5 bis 100 h in diesem Temperaturbereich gehalten werden.

10. Verfahren nach einem der Ansprüche 1 bis 9, dadurch gekennzeichnet, daß die Formteile bei einer Temperaturbehandlung zum Ausbilden einer Schmelzzone oder/und bei einer nachfolgenden Temperaturbehandlung zusätzlich bei Temperaturen zwischen 300 und 700 °C mindestens über 1 h getempert werden.

11. Verfahren nach einem der Ansprüche 1 bis 10, dadurch gekennzeichnet, daß auf oder in die Formteile vor dem Erzeugen einer Schmelzzone zusätzlich ein Keimkristall gebracht wird.

12. Hochtemperatursupraleitendes Formteil hergestellt nach einem der Ansprüche 1 bis 11, dadurch gekennzeichnet, daß sein Gefüge mindestens weitgehend einheitlich orientiert ist.

13. Hochtemperatursupraleitendes Formteil nach Anspruch 12, dadurch gekennzeichnet, daß die c-Achsen der Körner der supraleitenden Phasen näherungsweise parallel oder näherungsweise in einem Winkel kleiner 10 ° zu einer der Längsachsen des Formteile ausgerichtet sind.

14. Hochtemperatursupraleitendes Formteil nach Anspruch 12 oder 13, dadurch gekennzeichnet, daß es einkristalline Domänen größer als 8 mm, vorzugsweise größer als 20 mm enthält.

15. Hochtemperatursupraleitendes Formteil nach einem der Ansprüche 12 bis 14, dadurch gekennzeichnet, daß es keine Lunker aufweist.

16. Hochtemperatursupraleitendes Formteil nach einem der Ansprüche 12 bis 15, dadurch gekennzeichnet, daß es eine kritische Stromdichte j_{c} von mindestens 10000 A/cm² aufweist.

17. Verwendung der hochtemperatursupraleitenden Formteile nach einem der Ansprüche 12 bis 16 als Komponenten für Stromzuführungen, resistive oder induktive Strombegrenzer, Abschirmzylinder oder Permanentmagnete.
